# EUROPEAN PATENT APPLICATION

(11) **EP 4 832 693 A1**
(43) Date of publication of application: **28.10.2026**
(21) Application number: 26173673.0
(22) Date of filing: 21.04.2026
(51) Int. Cl.: H10F 19/80, H10F 77/30

(54) **SOLAR CELL MODULE AND PHOTOVOLTAIC POWER GENERATION SYSTEM**

(30) Priority: 24.04.2025 CN 202510526973
(71) Applicant: Tongwei Solar (Chengdu) Co., Ltd., Chengdu, Sichuan 610299 (CN)
(72) Inventor: YAN, Dengzhou, Chengdu, 610299 (CN); JI, Wei, Chengdu, 610299 (CN); SUN, Zehua, Chengdu, 610299 (CN); XIA, Zhengyue, Chengdu, 610299 (CN); XING, Guoqiang, Chengdu, 610299 (CN)
(74) Representative: Murgitroyd & Company

(57) **Abstract**

The present application provides a solar cell module, where a solar cell (103) is located between a first encapsulant film (102) and a second encapsulant film (104). At least one of the first encapsulant film (102) and the second encapsulant film (104) independently satisfies: an average transmittance for light from 280 nm to 320 nm is less than or equal to 5%, an average transmittance for light from 320 nm to 330 nm is from 25% to 30%, an average transmittance for light from 330 nm to 340 nm is from 60% to 65%, an average transmittance for light from 340 nm to 350 nm is from 85% to 88%, an average transmittance for light from 350 nm to 360 nm is from 88% to 90%, and an average transmittance for light in a wavelength range above 360 nm is greater than or equal to 90%.

## Description

### TECHNICAL FIELD

The present application relates to the field of photovoltaic technologies, and in particular, to a solar cell module and a photovoltaic power generation system.

### BACKGROUND

With the development of crystalline silicon solar cells towards high efficiency and thinness, crystalline silicon cells using materials such as aluminum oxide to form passivation layers have become the mainstream technical route due to low surface recombination rate and high carrier collection efficiency. However, the performance of such cells faces severe challenges from ultraviolet (UV) radiation during long-term service: doped layers (n+/p+ regions) and passivation layers on the cell surface are highly sensitive to short-wavelength ultraviolet light (<320 nm). The UV photon energy (>3.1 eV) triggers a significant increase in the interface recombination rate through intrinsic defects (such as oxygen vacancies), thereby leading to a cell efficiency degradation of more than 15% over a 25-year lifecycle. Especially in the UVB/UVA1 band near 320 nm, the transmittance is extremely high, which may penetrate traditional encapsulant films (such as EVA) and reach the cell surface, thereby directly damaging the crystal structure of the passivation layer and accelerating the deterioration of electrical performance.

Although traditional ultraviolet cut-off encapsulant films may block more than 90% of UVB near 320 nm, such films also have a high cut-off rate for wavelengths above 320 nm, which results in a high initial power loss of the solar cell module, exceeding 10 W, seriously violating the core design principle of "high reliability - high power". Therefore, how to effectively reduce the impact of ultraviolet light in wavelengths below 320 nm on the reliability of the solar cell module while improving the absorption and utilization of light in wavelengths above 320 nm by the solar cell module, thereby improving the module efficiency while enhancing the reliability of the solar cell module, has become one of the important research directions in the field.

### SUMMARY

Based on this, the present application provides a solar cell module and a photovoltaic power generation system. The solar cell module has high output power and good stability.

According to a first aspect of the present application, a solar cell module is provided, including a first cover plate, a first encapsulant film, a solar cell, a second encapsulant film, and a second cover plate. The first cover plate, the first encapsulant film, the second encapsulant film, and the second cover plate are sequentially stacked, and the solar cell is located between the first encapsulant film and the second encapsulant film. At least one of the first encapsulant film and the second encapsulant film independently satisfies the following conditions: an average transmittance for light in a wavelength range of 280 nm to 320 nm is less than or equal to 5%, an average transmittance for light in a wavelength range of 320 nm to 330 nm is from 25% to 30%, an average transmittance for light in a wavelength range of 330 nm to 340 nm is from 60% to 65%, an average transmittance for light in a wavelength range of 340 nm to 350 nm is from 85% to 88%, an average transmittance for light in a wavelength range of 350 nm to 360 nm is from 88% to 90%, and an average transmittance for light in a wavelength range above 360 nm is greater than or equal to 90%.

In the aforementioned solar cell module, an encapsulant film is used which has a low transmittance for light in a wavelength range below 320 nm and has a high slope of the transmittance curve between 320 nm and 360 nm; the encapsulant film may effectively cut off light below 320 nm, thereby reducing the adverse effects of ultraviolet light below 320 nm on the solar cell, which is beneficial for improving the stability of the solar cell module. Moreover, the encapsulant film has a high slope of the transmittance curve and a high transmittance for light above 320 nm, which is beneficial for the solar cell to fully utilize light above 320 nm, thereby enabling the solar cell module to have a high output power.

In any embodiment of the first aspect, a light-receiving surface of the solar cell is provided with an anti-reflection coating layer, a thickness of the anti-reflection coating layer ranges from 75 nm to 95 nm, and a refractive index of the anti-reflection coating layer ranges from 1.9 to 2.2.

In any embodiment of the first aspect, the thickness of the anti-reflection coating layer ranges from 70 nm to 90 nm, and the refractive index of the anti-reflection coating layer ranges from 2.00 to 2.05.

In any embodiment of the first aspect, a material of the anti-reflection coating layer includes one or more of silicon nitride, silicon oxide, and silicon oxynitride.

In any embodiment of the first aspect, at least one of the first cover plate and the second cover plate is a photovoltaic glass, and an average transmittance of the photovoltaic glass for light in a wavelength range below 320 nm is less than or equal to 51%.

In any embodiment of the first aspect, a thickness of the photovoltaic glass ranges from 1.6 mm to 3.2 mm.

In any embodiment of the first aspect, at least one of the first encapsulant film and the second encapsulant film contains 0.1% to 0.5% by mass of the encapsulant film of butyl 2-methylsalicylate, or contains 0.05% to 0.3% by mass of the encapsulant film of 2-(2'-hydroxy-3',5'-dicumenylphenyl)benzotriazole.

In any embodiment of the first aspect, at least one of the first encapsulant film and the second encapsulant film contains 0.05% to 1% by mass of the encapsulant film of a composite ultraviolet cut-off agent, and the composite ultraviolet cut-off agent includes the following components in mass percentage: 18% to 20% of a cyanoacrylate-based ultraviolet absorber, 8% to 10% of a triazine-based ultraviolet absorber, 28% to 32% of a hydroxybenzoate-based ultraviolet absorber, and 30% to 46% of an auxiliary additive.

In any embodiment of the first aspect, the cyanoacrylate-based ultraviolet absorber includes pentaerythritol tetrakis(2-cyano-3,3-diphenylacrylate); the triazine-based ultraviolet absorber includes 2-(4,6-diphenyl-1,3,5-triazin-2-yl)-5-(hexyloxy)phenol; the hydroxybenzoate-based ultraviolet absorber includes one or more of hexadecyl 3,5-di-tert-butyl-4-hydroxybenzoate and 3,5-di-tert-butyl-4-hydroxybenzoic acid 2,4-di-tert-butylphenyl ester.

In any embodiment, the hydroxybenzoate-based ultraviolet absorber includes hexadecyl 3,5-di-tert-butyl-4-hydroxybenzoate and 3,5-di-tert-butyl-4-hydroxybenzoic acid 2,4-di-tert-butylphenyl ester; based on a total mass of the composite ultraviolet cut-off agent, a mass percentage of the hexadecyl 3,5-di-tert-butyl-4-hydroxybenzoate ranges from 18% to 22%, and a mass percentage of the 3,5-di-tert-butyl-4-hydroxybenzoic acid 2,4-di-tert-butylphenyl ester ranges from 10% to 14%.

In any embodiment of the first aspect, the auxiliary additive includes one or more of 2,4-bis(2,4-dimethylphenyl)-6-(2-hydroxy-4-octyloxyphenyl)-1,3,5-triazine, 2'-(2'-hydroxy-3'-tert-butyl-5'-methylphenyl)-5-chlorobenzotriazole, 2-(2H-benzotriazol-2-yl)-4,6-bis(1-methyl-1-phenylethyl)phenol, 2-(2'-hydroxy-3',5'-di-tert-pentylphenyl)benzotriazole, 2-(2H-benzotriazol-2-yl)-6-(1-methyl-1-phenylethyl)-4-(1,1,3,3-tetramethylbutyl)phenol, 2-(2'-hydroxy-3',5'-di-tert-butylphenyl)-5-chlorobenzotriazole, 2-(2'-hydroxy-5'-tert-octylphenyl)benzotriazole, 2-hydroxy-4-n-octoxybenzophenone, 2,2'-methylenebis[6-(2H-benzotriazol-2-yl)-4-(1,1,3,3-tetramethylbutyl)phenol], 2-(2'-hydroxy-5'-methylphenyl)benzotriazole, a mixture of 2-[4-[(2-hydroxy-3-tridecyloxypropyl)oxy]-2-hydroxyphenyl]-4,6-bis(2,4-dimethylphenyl)-1,3,5-triazine and 2-[4-[(2-hydroxy-3-dodecyloxypropyl)oxy]-2-hydroxyphenyl]-4,6-bis(2,4-dimethylphenyl)-1,3,5-triazine, octyl 3-(3-(2H-benzo[d][1,2,3]triazol-2-yl)-5-(tert-butyl)-4-hydroxyphenyl)propanoate, and 3-[3-(2H-benzotriazol-2-yl)-4-hydroxy-5-tert-butylphenyl]-propionic acid-polyethylene glycol 300 ester.

In any embodiment of the first aspect, the auxiliary additive includes 2,4-bis(2,4-dimethylphenyl)-6-(2-hydroxy-4-octyloxyphenyl)-1,3,5-triazine and 2'-(2'-hydroxy-3'-tert-butyl-5'-methylphenyl)-5-chlorobenzotriazole; based on a total mass of the composite ultraviolet cut-off agent, a mass percentage of the 2,4-bis(2,4-dimethylphenyl)-6-(2-hydroxy-4-octyloxyphenyl)-1,3,5-triazine ranges from 20% to 25%, and a mass percentage of the 2'-(2'-hydroxy-3'-tert-butyl-5'-methylphenyl)-5-chlorobenzotriazole ranges from 10% to 22%.

In any embodiment of the first aspect, at least one of the first encapsulant film and the second encapsulant film includes 90% to 97.65% by mass of the encapsulant film of a polymer matrix.

In any embodiment of the first aspect, the polymer matrix includes one or more of ethylene-vinyl acetate copolymer, ethylene-octene copolymer, polyethylene, thermoplastic polyurethane, polyvinyl butyral, and polyethylene terephthalate.

In any embodiment of the first aspect, at least one of the first encapsulant film and the second encapsulant film includes a crosslinking agent, an antioxidant, a heat stabilizer, a tackifying resin, a plasticizer, a coupling agent, a co-crosslinking agent. The crosslinking agent is present in an amount of 1.0% to 1.2% by mass of the encapsulant film, the antioxidant is present in an amount of 0.2% to 0.5% by mass of the encapsulant film, the heat stabilizer is present in an amount of 0.8% to 1% by mass of the encapsulant film, the tackifying resin is present in an amount of 0% to 0.5% by mass of the encapsulant film, the plasticizer is present in an amount of 0% to 1.5% by mass of the encapsulant film, the coupling agent is present in an amount of 0.3% to 0.5% by mass of the encapsulant film, and the co-crosslinking agent is present in an amount of 0% to 0.5% by mass of the encapsulant film.

In any embodiment of the first aspect, the crosslinking agent includes one or more of an alkyl peroxide crosslinking agent, a diacyl peroxide crosslinking agent, and a peroxyketal crosslinking agent; the antioxidant includes a phosphite antioxidant; the heat stabilizer includes one or more of a phosphite heat stabilizer, a fatty acid salt heat stabilizer, and an epoxy compound heat stabilizer; the tackifying resin includes one or more of a terpene resin, a petroleum resin, a styrenic copolymer resin, and a phenolic resin; the plasticizer includes one or more of a phthalate plasticizer, an epoxy compound plasticizer, and a polyester plasticizer; the coupling agent includes a silane coupling agent; the co-crosslinking agent includes one or more of a multifunctional olefinic co-crosslinking agent, a peroxide co-crosslinking agent, and a silane co-crosslinking agent.

According to a second aspect of the present application, a photovoltaic power generation system is provided, including the solar cell module according to the first aspect of the present application.

### BRIEF DESCRIPTION OF THE DRAWINGS

To better describe and illustrate the embodiments or examples provided by the present application, reference may be made to one or more of the accompanying drawings. Additional details or examples used to describe the drawings should not be considered as limiting the scope of any of the disclosed applications, the currently described embodiments or examples, or the best mode of the application as currently understood. Moreover, throughout the drawings, the same reference numerals are used to denote the same components. In the drawings:
FIG. 1 is a schematic structural diagram of a solar cell module according to an embodiment of the present application;
FIG. 2 is a schematic structural diagram of an anti-reflection coating layer in the solar cell module shown in FIG. 1.
FIG.3 is another schematic structural diagram of a solar cell module according to an embodiment of the present application.
FIG. 4 is another schematic structural diagram of a solar cell module according to an embodiment of the present application.
FIG. 5 shows a transmittance curve of an ultraviolet cutoff adhesive film according to Example 7 of the present application.

### Reference Numerals:

100. solar cell module; 101. first cover plate; 102. first encapsulant film; 103. solar cell; 104. second encapsulant film; 105. second cover plate.

### DETAILED DESCRIPTION OF THE EMBODIMENTS

To make the above objectives, features, and advantages of the present application more comprehensible, a detailed description of specific embodiments of the present application is provided below. Many specific details are set forth in the following description to facilitate a full understanding of the present application. However, the present application may be implemented in many other ways different from those described herein. Those skilled in the art may make similar improvements without departing from the spirit of the present application. Therefore, the present application is not limited by the specific embodiments disclosed below.

Unless otherwise defined, all technical and scientific terms used herein have the same meanings as commonly understood by one of ordinary skill in the technical field to which the present application belongs. The terms used in the specification of the present application are for the purpose of describing specific embodiments only and are not intended to limit the present application. The term "and/or" as used herein includes any and all combinations of one or more related listed items. Unless otherwise specified, various raw materials, reagents, instruments, and equipment used in the present application may be obtained through market purchase or prepared by existing methods.

The terms "first" and "second" are used for descriptive purposes only and are not to be construed as indicating or implying relative importance or implicitly specifying the quantity of the indicated technical features. Thus, features defined with "first" or "second" may explicitly or implicitly include at least one such feature. In the description of the present application, "a plurality of" means at least two, such as two, three, and so on, unless otherwise specifically defined.

With the rapid development of solar cell technologies, higher requirements have been placed on the performance stability and output power of solar cell modules. The solar cell modules are affected by various environmental factors during actual use, among which ultraviolet radiation is an important factor leading to the degradation of the performance of the solar cell modules and has a significant impact on the stability of the solar cell modules. Therefore, how to improve the stability and the output power of the solar cell modules is one of the important research directions in the art.

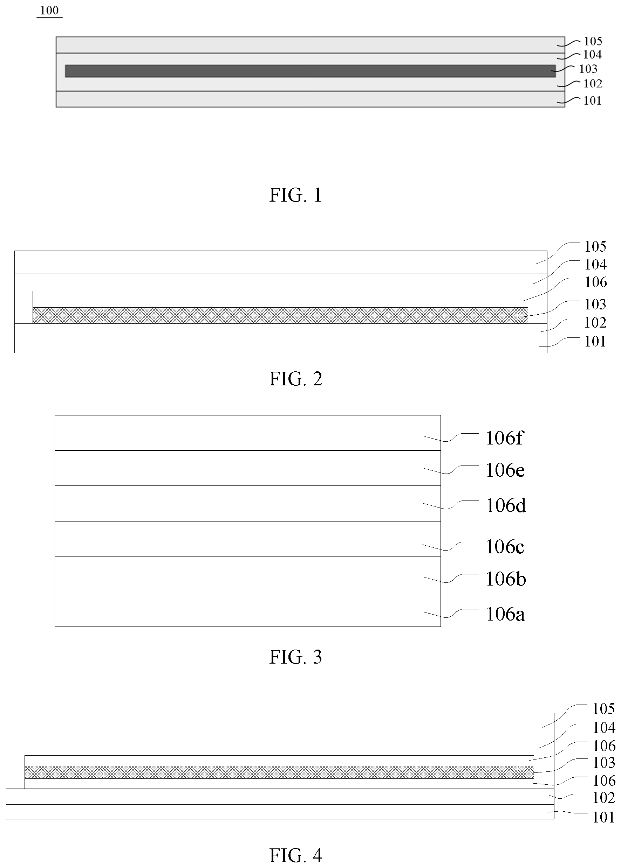

Based on this, referring to FIG. 1, an embodiment of the present application provides a solar cell module 100. The solar cell module 100 includes a first cover plate 101, a first encapsulant film 102, a solar cell 103, a second encapsulant film 104, and a second cover plate 105. The first cover plate 101, the first encapsulant film 102, the second encapsulant film 104, and the second cover plate 105 are sequentially stacked, and the solar cell 103 is located between the first encapsulant film 102 and the second encapsulant film 104. And at least one of the first encapsulant film and the second encapsulant film independently satisfies the following conditions: an average transmittance for light in a wavelength range of 280 nm to 320 nm is less than or equal to 5%, an average transmittance for light in a wavelength range of 320 nm to 330 nm is from 25% to 30%, an average transmittance for light in a wavelength range of 330 nm to 340 nm is from 60% to 65%, an average transmittance for light in a wavelength range of 340 nm to 350 nm is from 85% to 88%, an average transmittance for light in a wavelength range of 350 nm to 360 nm is from 88% to 90%, and an average transmittance for light in a wavelength range above 360 nm is greater than or equal to 90%.

By studying the impact of ultraviolet light on the stability and efficiency of the solar cell modules, it has been found that ultraviolet light in the wavelength band below 320 nm has a significant impact on the efficiency of solar cells, thereby affecting the stability of the cell modules; meanwhile, light in the wavelength band above 320 nm has a less obvious impact on the stability of some types of the solar cells, and light in the wavelength band may be absorbed and utilized by some types of the solar cells.

In the above solar cell module of the present application, an encapsulant film used has a low transmittance for light in a wavelength range below 320 nm and has a high slope of the transmittance curve between 320 nm and 360 nm. The encapsulant film may effectively cut off light below 320 nm, thereby reducing the adverse effects of ultraviolet light below 320 nm on the solar cell, which is beneficial for improving the stability of the solar cell module. Moreover, the encapsulant film has a high slope of the transmittance curve and a high transmittance for light above 320 nm, which is beneficial for the solar cell to fully utilize light above 320 nm, thereby improving the output power of the solar cell module. The solar cell module 100 has good stability and high output power.

It is understandable that both the first encapsulant film 102 and the second encapsulant film 104 may be encapsulant films satisfying the above transmittance conditions, or only one of the first encapsulant film 102 or the second encapsulant film 104 may be an encapsulant film satisfying the above transmittance conditions. In the case where only one of the first encapsulant film 102 or the second encapsulant film 104 is an encapsulant film satisfying the above transmittance conditions, the encapsulant film should face the light-receiving surface of the solar cell module 100. In some specific examples, both the first encapsulant film 102 and the second encapsulant film 104 are encapsulant films satisfying the above transmittance conditions. At least one of the first cover plate 101 and the second cover plate 105 is a transparent cover plate for light to enter.

It should be noted that the average transmittance for light in a certain wavelength band range mentioned above is obtained by testing the transmittance of light at a plurality of wavelengths within that wavelength range and then averaging the values. Taking the measurement of the average transmittance for light in a wavelength range of 320 nm to 330 nm as an example, it refers to measuring the transmittance for light at each wavelength of 320 nm, 321 nm, 322 nm, 323 nm... 328 nm, 329 nm, 330 nm, and so on, and averaging the measured transmittance data, and the average value is the average transmittance for light in the wavelength range of 320 nm to 330 nm.

Additionally, when calculating the average transmittance for different wavelength band ranges, the endpoints of the wavelength band ranges are included. For example: the average transmittance for light in the wavelength range of 320 nm to 330 nm calculates the average transmittance of the encapsulant film for the wavelength range of 320 nm to 330 nm; the average transmittance for light in the wavelength range of 330 nm to 340 nm calculates the average transmittance of the encapsulant film for the wavelength range of 330 nm to 340 nm. Therefore, the point of 330 nm is calculated twice.

In at least some embodiments, as shown in FIG. 2, the surface of the solar cell 103 has an anti-reflection coating layer 106. A thickness of the anti-reflection coating layer 106 ranges from 75 nm to 95 nm, and a refractive index of the anti-reflection coating layer 106 ranges from 1.9 to 2.2. The anti-reflection coating layer 106 on the surface of the solar cell 103 also has a certain cut-off effect on ultraviolet light below 320 nm. Cooperating with the first encapsulant film 102 and/or the second encapsulant film 104, it is beneficial to further reduce the adverse effects of light with wavelengths below 320 nm on the solar cell 103, thereby improving the stability of the solar cell module 100.

In at least some embodiments, as shown in FIG. 3, the anti-reflection coating layer 106 may include a plurality of stacked sub-film layers, such as a first sub-film layer 106a, a second sub-film layer 106b, a third sub-film layer 106c, a fourth sub-film layer 106d, a fifth sub-film layer 106e, and a sixth sub-film layer 106f. By adjusting parameters such as the materials and thicknesses of these film layers, an anti-reflection function is achieved. For example, the materials of the first sub-film layer 106a, the second sub-film layer 106b, the third sub-film layer 106c, the fourth sub-film layer 106d, the fifth sub-film layer 106e, and the sixth sub-film layer 106f may be SiNx1, SiNx2, SiNx3, SiNxOy1, SiNxOy2, SiOx, respectively, and the thicknesses may be 10 nm, 20 nm, 15 nm, 10 nm, 10 nm, and 10 nm, respectively.

For example, in the anti-reflection coating layer 106, the first sub-film layer 106a is adjacent to the solar cell 103, while the sixth sub-film layer 106f is farther away from the solar cell 103. The refractive index of the first sub-film layer 106a is smaller than that of the solar cell 103, and the refractive indices of the first sub-film layer 106a, the second sub-film layer 106b, the third sub-film layer 106c, the fourth sub-film layer 106d, the fifth sub-film layer 106e, and the sixth sub-film layer 106f decrease sequentially.

In at least some embodiments, the thickness of the anti-reflection coating layer 106 may be 75 nm, 76 nm, 77 nm, 78 nm, 79 nm, 80 nm, 81 nm, 82 nm, 83 nm, 84 nm, 85 nm, 86 nm, 87 nm, 88 nm, 89 nm, 90 nm, 91 nm, 92 nm, 93 nm, 94 nm, 95 nm, and any value within the range formed by any two of the above values. The refractive index of the anti-reflection coating layer may be 1.9, 1.92, 1.95, 1.98, 2.0, 2.02, 2.05, 2.08, 2.1, 2.12, 2.15, 2.18, 2.2, and any value within the range formed by any two of the above values. The anti-reflection coating layer 106 may be disposed on one side of the solar cell 103, as shown in FIG. 2, or the above-mentioned anti-reflection coating layer 106 may be disposed on both sides, as shown in FIG. 4.

It should be noted that in the case where the anti-reflection coating layer 106 is provided on only one side of the solar cell 103, the anti-reflection coating layer 106 may be located on the upper side of the solar cell 103 as shown in FIG. 2, that is, between the solar cell 103 and the second encapsulant film 104, or alternatively, it may be arranged on the lower side of the solar cell 103, that is, between the solar cell 103 and the first encapsulant film 102.

In at least some embodiments, the thickness of the anti-reflection coating layer 106 ranges from 80 nm to 90 nm, and the refractive index of the anti-reflection coating layer 106 ranges from 2.00 to 2.05. Controlling the thickness and refractive index of the anti-reflection coating layer 106 within the above ranges is more conducive to improving the stability and output power of the solar cell module.

For example, the thickness of the anti-reflection coating layer 106 may be about 80 nm to 90 nm, or may be 78±5 nm.

In at least some embodiments, a material of the anti-reflection coating layer 106 includes one or more of silicon nitride, silicon oxide, and silicon oxynitride; for example, silicon nitride. Using the above materials as the anti-reflection coating layer 106 on the surface of the solar cell 103 may effectively play an anti-reflection role and have a certain cut-off effect for light in a wavelength range below 320 nm.

In at least some embodiments, at least one of the first cover plate 101 and the second cover plate 105 is independently a photovoltaic glass, and the average transmittance of the photovoltaic glass for light in a wavelength range below 320 nm of less than or equal to 51%. Using the above-mentioned photovoltaic glass for the first cover plate 101 and/or the second cover plate 105, the photovoltaic glass also has a certain cut-off effect on light below 320 nm. Cooperating the photovoltaic glass with the above-mentioned encapsulant film and the anti-reflection coating layer 106 may make the light below 320 nm entering the internal film layers of the solar cell almost zero, which is beneficial to further reduce the adverse effects of ultraviolet light below 320 nm on the solar cell, thereby further improving the stability of the solar cell module.

In at least some embodiments, the first cover plate 101 and/or the second cover plate 105 may also independently be transparent panels or opaque panels of other materials. Specifically, when the first cover plate 101 or the second cover plate 105 is the light-receiving surface of the solar cell module 100, the photovoltaic glass or transparent panels of other materials may be used, and the photovoltaic glass is preferred; when the first cover plate 101 or the second cover plate 105 is the backlight surface of the solar cell module 100, the photovoltaic glass, the transparent panels of other materials, or opaque panels may be used.

In some specific examples, a thickness of the photovoltaic glass ranges from 1.6mm to 3.2 mm, for example, 2 mm. Controlling the thickness of the photovoltaic glass within the above ranges is beneficial for the photovoltaic glass to have a good cut-off effect on ultraviolet light below 320 nm, while taking into account cost and transmittance for light above 320 nm. If the thickness of the photovoltaic glass is too thin, the cut-off effect of the photovoltaic glass on ultraviolet light below 320 nm will be poor, thereby affecting the stability of the module; if the thickness of the photovoltaic glass is too thick, on one hand, it will increase the cost of the module, and on the other hand, it may reduce the transmittance for light above 320 nm, thereby affecting the output power of the module.

Understandably, the thickness of the photovoltaic glass may be 1.6 mm, 1.7 mm, 1.8 mm, 1.9 mm, 2.0 mm, 2.1 mm, 2.2 mm, 2.3 mm, 2.4 mm, 2.5 mm, 2.6 mm, 2.7 mm, 2.8 mm, 2.9 mm, 3.0 mm, 3.1 mm, 3.2 mm, and any value within the range formed by any two of the above values.

The present application, by adopting an encapsulant film that has a low transmittance for light in a wavelength range below 320 nm and a high slope of the transmittance curve between 320 nm and 360 nm, and by synergistically cooperating with the photovoltaic glass and the anti-reflection coating layer 106, may effectively improve the stability of the solar cell module and enable the solar cell module to have a high output power.

In some embodiments, the solar cell 103 is a TOPCon solar cell. The TOPCon solar cell includes a silicon substrate, a tunnel oxide layer, a doped polysilicon layer, a front side passivation layer, a front side anti-reflection layer, a back side passivation layer, a back side anti-reflection layer, a front side electrode, and a back side electrode. The tunnel oxide layer, the doped polysilicon layer, the back side passivation layer, and the back side anti-reflection layer are sequentially stacked on the back side of the silicon substrate. The front side passivation layer and the front side anti-reflection layer are sequentially stacked on the front side of the silicon substrate. The front side electrode is disposed on the front side anti-reflection layer and contacts the front side of the silicon substrate through the front side anti-reflection layer. The back side electrode is disposed on the back side anti-reflection layer and contacts the doped polysilicon layer through the back side anti-reflection layer. The tunnel oxide layer and the doped polysilicon layer form a poly passivated contact structure on the back side of the silicon substrate.

Research has found that ultraviolet light below 320 nm has a significant impact on the efficiency of the TOPCon solar cell, thereby affecting the stability of the solar cell module. Light with wavelengths above 320 nm has a negligible impact on the stability of the TOPCon solar cell, and light in the wavelength range may be absorbed and utilized by the TOPCon solar cell. Using the TOPCon solar cell as the solar cell in the solar cell module may provide the module with good stability and high output power.

In some specific examples, at least one of the first encapsulant film 102 and the second encapsulant film 104 contains 0.1% to 0.5% by mass of the encapsulant film of butyl 2-methylsalicylate(CAS No. 51115-63-0), or contains 0.05% to 0.3% by mass of the encapsulant film of 2-(2'-hydroxy-3',5'-dicumenylphenyl)benzotriazole(CAS No. 70321-86-7). Using the above-mentioned amount of butyl 2-methylsalicylate or the above-mentioned amount of 2-(2'-hydroxy-3',5'-dicumenylphenyl)benzotriazole as a single ultraviolet cut-off agent in the first encapsulant film 102 and/or the second encapsulant film 104 may enable the encapsulant film to have a low transmittance for light in a wavelength range below 320 nm and a high slope of the transmittance curve between 320 nm and 360 nm, which is beneficial for improving the stability and output power of the solar cell module.

Understandably, when butyl 2-methylsalicylate is used as the ultraviolet cut-off agent, the content of butyl 2-methylsalicylate in the encapsulant film may be 0.1%, 0.15%, 0.2%, 0.25%, 0.3%, 0.35%, 0.4%, 0.45%, 0.5%, and any value within the range formed by any two of the above numerical values. When 2-(2'-hydroxy-3',5'-dicumenylphenyl)benzotriazole is used as the ultraviolet cut-off agent, the content of 2-(2'-hydroxy-3',5'-dicumenylphenyl)benzotriazole in the encapsulant film may be 0.05%, 0.08%, 0.1%, 0.12%, 0.15%, 0.18%, 0.2%, 0.22%, 0.25%, 0.28%, 0.3%, or any value within the range formed by any two of the above numerical values.

In other specific examples, at least one of the first encapsulant film 102 and the second encapsulant film 104 contains 0.05% to 1% by mass of the encapsulant film of a composite ultraviolet cut-off agent, and the composite ultraviolet cut-off agent includes the following components in mass percentage: 18% to 20% of a cyanoacrylate-based ultraviolet absorber, 8% to 10% of a triazine-based ultraviolet absorber, 28% to 32% of a hydroxybenzoate-based ultraviolet absorber, and 30% to 46% of an auxiliary additive.

For example, a specific content of the above composite ultraviolet cut-off agent may be added to the first encapsulant film 102 and/or the second encapsulant film 104. In the composite ultraviolet cut-off agent, the core structure of the cyanoacrylate-based ultraviolet absorber is a benzene ring connected to an acrylate group. Through its π→π* electronic transition, it may effectively absorb ultraviolet light in a wavelength range of 280 nm to 330 nm, thereby providing a good absorption foundation at 320 nm. The triazine-based ultraviolet absorber has a large conjugated system and multiple electron-withdrawing groups, giving it strong absorption capacity for ultraviolet light of 320 nm to 340 nm range. It may further increase the slope of the transmittance curve of the encapsulant film based on the absorption of UV3030. The hydroxybenzoate-based ultraviolet absorber functions through the conjugated system absorption, energy transfer, and free radical capture mechanisms of its molecules. It may absorb ultraviolet light energy in the range of 290nm to 330 nm to assist other ultraviolet absorbers in enhancing the absorption effect of ultraviolet light at 320 nm.

By adding a specified amount of the above composite ultraviolet cut-off agent to the encapsulant film, and by synergistically combining the cyanoacrylate-based ultraviolet absorber, the triazine-based ultraviolet absorber, and the hydroxybenzoate-based ultraviolet absorber in the composite ultraviolet cut-off agent at specific dosages, the encapsulant film may efficiently absorb ultraviolet light with wavelengths below 320 nm, thereby reducing the impact of ultraviolet light below 320 nm in sunlight on the stability of the solar cell module; moreover, the transmittance curve of the encapsulant film has a high slope, thereby minimizing the absorption of light above 320 nm. This is beneficial for the solar cell module to utilize light with wavelengths above 320 nm and helps improve the output power of the module.

Understandably, among the first encapsulant film 102 and the second encapsulant film 104, both may include the aforementioned ultraviolet cut-off agent, or only the first encapsulant film 102 or the second encapsulant film 104 may include the aforementioned composite ultraviolet cut-off agent. In the case where only the first encapsulant film 102 or the second encapsulant film 104 includes the aforementioned composite ultraviolet cut-off agent, the encapsulant film containing the composite ultraviolet cut-off agent should face the light-receiving surface of the solar cell module 100. In some specific examples, both the first encapsulant film 102 and the second encapsulant film 104 include the aforementioned ultraviolet cut-off agent.

The mass fraction of the composite ultraviolet cut-off agent in the encapsulant film may be 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, or any value within the range formed by any two of the above numerical values. Further, the mass fraction of the ultraviolet cut-off agent in the encapsulant film may be 0.3% to 0.5%; even further, it may be 0.4%.

Further, the ultraviolet cut-off agent includes the following components by mass percentage: 18% to 20% of a cyanoacrylate-based ultraviolet absorber, 8% to 10% of a triazine-based ultraviolet absorber, 28% to 32% of a hydroxybenzoate-based ultraviolet absorber, and 30% to 46% of an auxiliary additive. Controlling the amounts of the cyanoacrylate-based ultraviolet absorber, the triazine-based ultraviolet absorber, and the hydroxybenzoate-based ultraviolet absorber in the ultraviolet cut-off agent within the above ranges is more conducive to improving the cut-off effect of the encapsulant film on ultraviolet light below 320 nm, thereby increasing the slope of the transmittance curve, and thus more beneficial for improving the stability and output power of the solar cell module.

Specifically, the cyanoacrylate-based ultraviolet absorber includes pentaerythritol tetrakis(2-cyano-3,3-diphenylacrylate) (UV3030; CAS: 178671-58-4); the triazine-based ultraviolet absorber includes 2-(4,6-diphenyl-1,3,5-triazin-2-yl)-5-(hexyloxy)phenol (UV1577; CAS: 147315-50-2); the hydroxybenzoate-based ultraviolet absorber includes one or more of hexadecyl 3,5-di-tert-butyl-4-hydroxybenzoate (UV2908; CAS: 67845-93-6) and 3,5-di-tert-butyl-4-hydroxybenzoic acid 2,4-di-tert-butylphenyl ester (UV120; CAS: 4221-80-1).

In some specific examples, the hydroxybenzoate-based ultraviolet absorber includes hexadecyl 3,5-di-tert-butyl-4-hydroxybenzoate (UV2908) and 3,5-di-tert-butyl-4-hydroxybenzoic acid 2,4-di-tert-butylphenyl ester (UV120); and based on a total mass of the ultraviolet cut-off agent, a mass percentage of the hexadecyl 3,5-di-tert-butyl-4-hydroxybenzoate ranges from 18% to 22%, and a mass percentage of the 3,5-di-tert-butyl-4-hydroxybenzoic acid 2,4-di-tert-butylphenyl ester ranges from 10% to 14%.

The carbonyl group in the UV2908 molecule forms a conjugated system with the benzene ring, which may absorb ultraviolet light of 290 nm to 320 nm, connecting with the absorption ranges of UV3030 and UV1577 and supplementing the ultraviolet absorption on the shorter wavelength side. UV120 primarily functions through energy transfer and free radical capture mechanisms, thereby absorbing ultraviolet light in the range of 300 nm to 330 nm. It may assist other ultraviolet absorbers in enhancing the absorption effect of ultraviolet light at 320 nm, while improving the light stability of the system, thereby preventing yellowing of the encapsulant film under ultraviolet irradiation.

Furthermore, UV2908 is relatively acidic, and excessive amounts may lead to a decrease in the damp-heat reliability of the encapsulant film. UV120 has a high refractive index, and excessive amounts may lead to poor compatibility with the polymer matrix in the encapsulant film, thereby posing a risk of precipitation and potentially reducing the mechanical properties of the encapsulant film. By using UV2908 and UV120 in appropriate amounts in combination, it is possible to achieve a good supplementary and auxiliary ultraviolet absorption effect while avoiding the aforementioned drawbacks associated with their individual use.

In some embodiments, the auxiliary additive in the ultraviolet cut-off agent includes one or more of 2,4-bis(2,4-dimethylphenyl)-6-(2-hydroxy-4-octyloxyphenyl)-1,3,5-triazine (UV1164; CAS: 2725-22-6), 2'-(2'-hydroxy-3'-tert-butyl-5'-methylphenyl)-5-chlorobenzotriazole (UV326; CAS: 3896-11-5), 2-(2H-benzotriazol-2-yl)-4,6-bis(1-methyl-1-phenylethyl)phenol (UV234; CAS: 70321-86-7), 2-(2'-hydroxy-3',5'-di-tert-pentylphenyl)benzotriazole (UV328; CAS: 25973-55-1), 2-(2H-benzotriazol-2-yl)-6-(1-methyl-1-phenylethyl)-4-(1,1,3,3-tetramethylbutyl)phenol (UV928; CAS: 73936-91-1), 2-(2'-hydroxy-3',5'-di-tert-butylphenyl)-5-chlorobenzotriazole (UV327; CAS: 3864-99-1), 2-(2'-hydroxy-5'-tert-octylphenyl)benzotriazole (UV329; CAS: 3147-75-9), 2-hydroxy-4-n-octoxybenzophenone (UV531; CAS: 1843-05-6), 2,2'-methylenebis[6-(2H-benzotriazol-2-yl)-4-(1,1,3,3-tetramethylbutyl)phenol] (UV360; CAS: 103597-45-1), 2-(2'-hydroxy-5'-methylphenyl)benzotriazole (UV-P; CAS: 2440-22-4), a mixture of 2-[4-[(2-hydroxy-3-tridecyloxypropyl)oxy]-2-hydroxyphenyl]-4,6-bis(2,4-dimethylphenyl)-1,3,5-triazine and 2-[4-[(2-hydroxy-3-dodecyloxypropyl)oxy]-2-hydroxyphenyl]-4,6-bis(2,4-dimethylphenyl)-1,3,5-triazine (UV400; CAS: 153519-44-9), octyl 3-(3-(2H-benzo[d][1,2,3]triazol-2-yl)-5-(tert-butyl)-4-hydroxyphenyl)propanoate (UV384-2; CAS: 127519-17-9), and 3-[3-(2H-benzotriazol-2-yl)-4-hydroxy-5-tert-butylphenyl]-propionic acid-polyethylene glycol 300 ester (UV1130; CAS: 104810-48-2). Combining the above auxiliary additives with UV3030, UV1577, UV2908, and UV120 is beneficial for further improving the performance of the encapsulant film, such as the cut-off effect on ultraviolet light below 320 nm, the efficiency of the transmittance curve of the encapsulant film, and the light aging resistance of the encapsulant film.

In some specific examples, the auxiliary additive includes 2,4-bis(2,4-dimethylphenyl)-6-(2-hydroxy-4-octyloxyphenyl)-1,3,5-triazine and 2'-(2'-hydroxy-3'-tert-butyl-5'-methylphenyl)-5-chlorobenzotriazole; and based on a total mass of the ultraviolet cut-off agent, a mass percentage of the 2,4-bis(2,4-dimethylphenyl)-6-(2-hydroxy-4-octyloxyphenyl)-1,3,5-triazine ranges from 20% to 25%, and a mass percentage of the 2'-(2'-hydroxy-3'-tert-butyl-5'-methylphenyl)-5-chlorobenzotriazole ranges from 10% to 22%.

The 2,4-bis(2,4-dimethylphenyl)-6-(2-hydroxy-4-octyloxyphenyl)-1,3,5-triazine is an o-hydroxyphenyl triazine light stabilizer and also an ultraviolet absorber. It may capture free radicals generated during the photo-oxidative degradation process of the polymer matrix in the encapsulant film and decompose hydroperoxides produced during the photo-oxidation of the polymer matrix, thereby inhibiting the photo-oxidation reaction. It also has a certain absorption capacity in the wavelength range of 310 nm to 335 nm. Synergizing with other ultraviolet absorbers, thereby helping to enhance the absorption performance at 320 nm and the light aging resistance of the encapsulant film, and thus preventing yellowing of the encapsulant film.

2'-(2'-hydroxy-3'-tert-butyl-5'-methylphenyl)-5-chlorobenzotriazole is a benzotriazole ultraviolet absorber with good absorption effect for ultraviolet light in the wavelength range of 320 nm to 345 nm. It may cooperate with UV3030 to strengthen the absorption of ultraviolet light at and near 320 nm, thereby increasing the slope of the transmittance curve of the encapsulant film.

Understandably, the mass percentage of the 2,4-bis(2,4-dimethylphenyl)-6-(2-hydroxy-4-octyloxyphenyl)-1,3,5-triazine in the composite ultraviolet cut-off agent may be 20%, 20.5%, 21%, 21.5%, 22%, 22.5%, 23%, 23.5%, 24%, 24.5%, 25%, or any value within the range formed by any two of the above values; the mass percentage of the 2'-(2'-hydroxy-3'-tert-butyl-5'-methylphenyl)-5-chlorobenzotriazole may be 10%, 11%, 12%, 13%, 14%, 15%, 16%, 17%, 18%, 19%, 20%, 21%, 22%, or any value within the range formed by any two of the above values.

In at least some embodiments, at least one of the first encapsulant film and the second encapsulant film includes 90% to 98% by mass of the encapsulant film of a polymer matrix. The polymer matrix includes one or more of ethylene-vinyl acetate copolymer (EVA), ethylene-octene copolymer (POE), polyethylene (PE), thermoplastic polyurethane (TPU), and polyethylene terephthalate (PET). The aforementioned polymer matrix is the main component of the encapsulant film, and capable of generating good adhesion with the surfaces of components such as the solar cell and the cover plates, thereby firmly encapsulating the solar cell between the cover plates to form a stable integrated structure.

In at least some embodiments, at least one of the first encapsulant film 102 and the second encapsulant film 104 includes one or more of a crosslinking agent, an antioxidant, a heat stabilizer, a tackifying resin, a plasticizer, a coupling agent, and a co-crosslinking agent. The crosslinking agent is present in an amount of 1.0% to 1.2% by mass of the encapsulant film, the antioxidant is present in an amount of 0.2% to 0.5% by mass of the encapsulant film, the heat stabilizer is present in an amount of 0.8% to 1% by mass of the encapsulant film, the tackifying resin is present in an amount of 0% to 0.5% by mass of the encapsulant film, the plasticizer is present in an amount of 0% to 1.5% by mass of the encapsulant film, the coupling agent is present in an amount of 0.3% to 0.5% by mass of the encapsulant film, and the co-crosslinking agent is present in an amount of 0% to 0.5% by mass of the encapsulant film.

Among them, the crosslinking agent includes one or more of an alkyl peroxide crosslinking agent, a diacyl peroxide crosslinking agent, and a peroxyketal crosslinking agent, such as bis(tert-butylperoxyisopropyl)benzene. The antioxidant includes a phosphite antioxidant, such as tetrakis(2,4-di-tert-butylphenyl) 4,4'-biphenyldiphosphonite (P-EPQ). Compared to commonly used hindered phenol antioxidants, phosphite antioxidants have a larger P-C bond energy, better stability, and are less prone to causing yellowing of the encapsulant film. The heat stabilizer may be one or more of a phosphite heat stabilizer, a fatty acid salt heat stabilizer, and an epoxy compound heat stabilizer. The tackifying resin may be one or more of a terpene resin, a petroleum resin, a styrenic copolymer resin, and a phenolic resin; the plasticizer may be one or more of a phthalate plasticizer, an epoxy compound plasticizer, and a polyester plasticizer. The coupling agent may be a silane coupling agent, such as the KH570 silane coupling agent. The co-crosslinking agent may be one or more of a multifunctional olefinic co-crosslinking agent, a peroxide co-crosslinking agent, and a silane co-crosslinking agent, such as triallyl cyanurate (TAC).

In one embodiment of the present application, a photovoltaic power generation system is provided. The photovoltaic power generation system includes the aforementioned solar cell module 100 of the present application. By adopting the aforementioned solar cell module 100 of the present application, the photovoltaic power generation system of the present application has good stability and high output power.

The photovoltaic power generation system utilizes the solar cell 103 in the solar cell module 100 to directly convert solar radiation energy into electricity, thereby offering high efficiency and good stability. The solar cell module 100 is the core component of the photovoltaic power generation system. In the aforementioned photovoltaic power generation system, it includes one or more solar cell modules 100, which may be selected according to specific application scenarios; further, when the aforementioned photovoltaic power generation system includes multiple solar cell modules 100, the multiple solar cell modules 100 form a photovoltaic array. The aforementioned photovoltaic power generation system may be a stand-alone photovoltaic power generation system or a grid-connected photovoltaic power generation system.

In one embodiment of the present application, an ultraviolet cut-off encapsulant film is provided (which may correspond to at least one of the first encapsulant film and the second encapsulant film in the foregoing embodiments). The ultraviolet cut-off encapsulant film contains 0.1% to 0.5% by mass of the encapsulant film of butyl 2-methylsalicylate, or contains 0.05% to 0.3% by mass of the encapsulant film of 2-(2'-hydroxy-3',5'-dicumenylphenyl)benzotriazole, or contains 0.05% to 1% by mass of the encapsulant film of a composite ultraviolet cut-off agent, and the composite ultraviolet cut-off agent includes the following components in mass percentage: 18% to 20% of a cyanoacrylate-based ultraviolet absorber, 8% to 10% of a triazine-based ultraviolet absorber, 28% to 32% of a hydroxybenzoate-based ultraviolet absorber, and 30% to 46% of an auxiliary additive.

The ultraviolet cut-off encapsulant film has a low transmittance for light in a wavelength range below 320 nm, and a high slope of the transmittance curve between 320 nm and 360 nm, which is beneficial for improving the stability and output power of the solar cell module 100.

In at least some embodiments, the cyanoacrylate-based ultraviolet absorber includes pentaerythritol tetrakis(2-cyano-3,3-diphenylacrylate); the triazine-based ultraviolet absorber includes 2-(4,6-diphenyl-1,3,5-triazin-2-yl)-5-(hexyloxy)phenol; the hydroxybenzoate-based ultraviolet absorber includes one or more of hexadecyl 3,5-di-tert-butyl-4-hydroxybenzoate and 3,5-di-tert-butyl-4-hydroxybenzoic acid 2,4-di-tert-butylphenyl ester.

In at least some embodiments, the hydroxybenzoate-based ultraviolet absorber includes hexadecyl 3,5-di-tert-butyl-4-hydroxybenzoate and 3,5-di-tert-butyl-4-hydroxybenzoic acid 2,4-di-tert-butylphenyl ester; based on a total mass of the ultraviolet cut-off agent, a mass percentage of the hexadecyl 3,5-di-tert-butyl-4-hydroxybenzoate ranges from 18% to 22%, and a mass percentage of the 3,5-di-tert-butyl-4-hydroxybenzoic acid 2,4-di-tert-butylphenyl ester ranges from 10% to 14%.

In at least some embodiments, the auxiliary additive includes one or more of 2,4-bis(2,4-dimethylphenyl)-6-(2-hydroxy-4-octyloxyphenyl)-1,3,5-triazine, 2'-(2'-hydroxy-3'-tert-butyl-5'-methylphenyl)-5-chlorobenzotriazole, 2-(2H-benzotriazol-2-yl)-4,6-bis(1-methyl-1-phenylethyl)phenol, 2-(2'-hydroxy-3',5'-di-tert-pentylphenyl)benzotriazole, 2-(2H-benzotriazol-2-yl)-6-(1-methyl-1-phenylethyl)-4-(1,1,3,3-tetramethylbutyl)phenol, 2-(2'-hydroxy-3',5'-di-tert-butylphenyl)-5-chlorobenzotriazole, 2-(2'-hydroxy-5'-tert-octylphenyl)benzotriazole, 2-hydroxy-4-n-octoxybenzophenone, 2,2'-methylenebis[6-(2H-benzotriazol-2-yl)-4-(1,1,3,3-tetramethylbutyl)phenol], 2-(2'-hydroxy-5'-methylphenyl)benzotriazole, a mixture of 2-[4-[(2-hydroxy-3-tridecyloxypropyl)oxy]-2-hydroxyphenyl]-4,6-bis(2,4-dimethylphenyl)-1,3,5-triazine and 2-[4-[(2-hydroxy-3-dodecyloxypropyl)oxy]-2-hydroxyphenyl]-4,6-bis(2,4-dimethylphenyl)-1,3,5-triazine, octyl 3-(3-(2H-benzo[d][1,2,3]triazol-2-yl)-5-(tert-butyl)-4-hydroxyphenyl)propanoate, and 3-[3-(2H-benzotriazol-2-yl)-4-hydroxy-5-tert-butylphenyl]-propionic acid-polyethylene glycol 300 ester.

In at least some embodiments, the auxiliary additive includes 2,4-bis(2,4-dimethylphenyl)-6-(2-hydroxy-4-octyloxyphenyl)-1,3,5-triazine and 2'-(2'-hydroxy-3'-tert-butyl-5'-methylphenyl)-5-chlorobenzotriazole; based on a total mass of the ultraviolet cut-off agent, a mass percentage of the 2,4-bis(2,4-dimethylphenyl)-6-(2-hydroxy-4-octyloxyphenyl)-1,3,5-triazine ranges from 20% to 25%, and a mass percentage of the 2'-(2'-hydroxy-3'-tert-butyl-5'-methylphenyl)-5-chlorobenzotriazole ranges from 10% to 22%.

In at least some embodiments, the ultraviolet cut-off encapsulant film further includes 90% to 97.65% by mass of the encapsulant film of a polymer matrix. The polymer matrix includes one or more of ethylene-vinyl acetate copolymer, ethylene-octene copolymer, polyethylene, thermoplastic polyurethane, and polyethylene terephthalate.

In at least some embodiments, the ultraviolet cut-off encapsulant film optionally further includes a crosslinking agent, an antioxidant, a heat stabilizer, a tackifying resin, a plasticizer, a coupling agent, and a co-crosslinking agent. The crosslinking agent is present in an amount of 1.0% to 1.2% by mass of the encapsulant film, the antioxidant is present in an amount of 0.2% to 0.5% by mass of the encapsulant film, the heat stabilizer is present in an amount of 0.8% to 1% by mass of the encapsulant film, the tackifying resin is present in an amount of 0% to 0.5% by mass of the encapsulant film, the plasticizer is present in an amount of 0% to 1.5% by mass of the encapsulant film, the coupling agent is present in an amount of 0.3% to 0.5% by mass of the encapsulant film, and the co-crosslinking agent is present in an amount of 0% to 0.5% by mass of the encapsulant film.

For example, the crosslinking agent includes one or more of an alkyl peroxide crosslinking agent, a diacyl peroxide crosslinking agent, and a peroxyketal crosslinking agent, such as bis(tert-butylperoxyisopropyl)benzene. The antioxidant includes a phosphite antioxidant, such as tetrakis(2,4-di-tert-butylphenyl) 4,4'-biphenyldiphosphonite. The heat stabilizer may be one or more of a phosphite heat stabilizer, a fatty acid salt heat stabilizer, and an epoxy compound heat stabilizer. The tackifying resin may be one or more of a terpene resin, a petroleum resin, a styrenic copolymer resin, and a phenolic resin; the plasticizer may be one or more of a phthalate plasticizer, an epoxy compound plasticizer, and a polyester plasticizer. The coupling agent may be a silane coupling agent, such as the KH570 silane coupling agent. The co-crosslinking agent may be one or more of a multifunctional olefinic co-crosslinking agent, a peroxide co-crosslinking agent, and a silane co-crosslinking agent, such as triallyl cyanurate.

The present application will be further illustrated below with reference to specific examples and comparative examples, but this should not be construed as limiting the scope of protection of the present application.

### Example 1:

### (1) Preparation of ultraviolet cut-off encapsulant film

EVA as a polymer matrix, butyl 2-methylsalicylate as an ultraviolet cut-off agent, di(tert-butylperoxyisopropyl)benzene as a crosslinking agent, P-EPQ as an antioxidant, zinc stearate as a heat stabilizer, petroleum resin as a tackifying resin, KH570 silane coupling agent as a coupling agent, and triallyl cyanurate as a co-crosslinking agent were mixed uniformly in a high-speed mixer according to mass percentages of 95.6%, 0.4%, 1.0%, 0.5%, 1%, 0.5%, 0.5%, and 0.5%, respectively; the above mixed material was melt-extruded through a twin-screw extruder and then cast-formed to obtain the ultraviolet cut-off encapsulant film.

### (2) Preparation of solar cell module

A photovoltaic glass cover plate having a thickness of 2 mm, the aforementioned ultraviolet cut-off encapsulant film with a basis weight of 420g/m², a TOPCon solar cell, the aforementioned ultraviolet cut-off encapsulant film with a basis weight of 420g/m², and a photovoltaic glass cover plate having a thickness of 2 mm were sequentially stacked and laminated to obtain a TOPCon solar cell module. Among them, the TOPCon solar cell had a silicon nitride anti-reflection layer having a thickness of 85 nm on both the front side and the back side thereof; the photovoltaic glass cover plate had an average transmittance for light in a wavelength range below 320 nm of less than 51%.

### Example 2:

The example was basically the same as Example 1, with the difference being: in step (1), the mass percentages of EVA as a polymer matrix, butyl 2-methylsalicylate as an ultraviolet cut-off agent, di(tert-butylperoxyisopropyl)benzene as a crosslinking agent, P-EPQ as an antioxidant, zinc stearate as a heat stabilizer, petroleum resin as a tackifying resin, KH570 silane coupling agent as a coupling agent, and triallyl cyanurate as a co-crosslinking agent were 95.9%, 0.1%, 1.0%, 0.5%, 1%, 0.5%, 0.5%, and 0.5%, respectively.

### Example 3:

The example was basically the same as Example 1, with the difference being: in step (1), the mass percentages of EVA as a polymer matrix, butyl 2-methylsalicylate as an ultraviolet cut-off agent, di(tert-butylperoxyisopropyl)benzene as a crosslinking agent, P-EPQ as an antioxidant, zinc stearate as a heat stabilizer, petroleum resin as a tackifying resin, KH570 silane coupling agent as a coupling agent, and triallyl cyanurate as a co-crosslinking agent were 95.5%, 0.5%, 1.0%, 0.5%, 1%, 0.5%, 0.5%, and 0.5%, respectively.

### Example 4:

### (1) Preparation of ultraviolet cut-off encapsulant film

EVA as a polymer matrix, 2-(2'-hydroxy-3',5'-dicumenylphenyl)benzotriazole as an ultraviolet cut-off agent, di(tert-butylperoxyisopropyl)benzene as a crosslinking agent, P-EPQ as an antioxidant, zinc stearate as a heat stabilizer, petroleum resin as a tackifying resin, KH570 silane coupling agent as a coupling agent, and triallyl cyanurate as a co-crosslinking agent were mixed uniformly in a high-speed mixer according to mass percentages of 95.7%, 0.3%, 1.0%, 0.5%, 1%, 0.5%, 0.5%, and 0.5%, respectively; the above mixed material was melt-extruded through a twin-screw extruder and then cast-formed to obtain the ultraviolet cut-off encapsulant film.

### (2) Preparation of solar cell module

A photovoltaic glass cover plate having a thickness of 2 mm, the aforementioned ultraviolet cut-off encapsulant film with a basis weight of 420 g/m², a TOPCon solar cell, the aforementioned ultraviolet cut-off encapsulant film with a basis weight of 420 g/m², and a photovoltaic glass cover plate having a thickness of 2 mm were sequentially stacked and laminated to obtain a TOPCon solar cell module. Among them, the TOPCon solar cell had a silicon nitride anti-reflection layer having a thickness of 85nm on both the front side and the back side thereof; the photovoltaic glass cover plate had an average transmittance for light in a wavelength range below 320 nm of less than 51%.

### Example 5:

The example was basically the same as Example 4, with the difference being: in step (1), the mass percentages of EVA as a polymer matrix, 2-(2'-hydroxy-3',5'-dicumenylphenyl)benzotriazole as an ultraviolet cut-off agent, di(tert-butylperoxyisopropyl)benzene as a crosslinking agent, P-EPQ as an antioxidant, zinc stearate as a heat stabilizer, petroleum resin as a tackifying resin, KH570 silane coupling agent as a coupling agent, and triallyl cyanurate as a co-crosslinking agent were 95.9%, 0.1%, 1.0%, 0.5%, 1%, 0.5%, 0.5%, and 0.5%, respectively.

### Example 6:

The example was basically the same as Example 4, with the difference being: in step (1), the mass percentages of EVA as a polymer matrix, 2-(2'-hydroxy-3',5'-dicumenylphenyl)benzotriazole as an ultraviolet cut-off agent, di(tert-butylperoxyisopropyl)benzene as a crosslinking agent, P-EPQ as an antioxidant, zinc stearate as a heat stabilizer, petroleum resin as a tackifying resin, KH570 silane coupling agent as a coupling agent, and triallyl cyanurate as a co-crosslinking agent are 95.95%, 0.05%, 1.0%, 0.5%, 1%, 0.5%, 0.5%, and 0.5%, respectively.

### Example 7:

### (1) Preparation of ultraviolet cut-off encapsulant film

EVA as a polymer matrix, a composite ultraviolet cut-off agent, di(tert-butylperoxyisopropyl)benzene as a crosslinking agent, P-EPQ as an antioxidant, zinc stearate as a heat stabilizer, petroleum resin as a tackifying resin, KH570 silane coupling agent as a coupling agent, and triallyl cyanurate as a co-crosslinking agent were mixed uniformly in a high-speed mixer according to mass percentages of 95.6%, 0.4%, 1.0%, 0.5%, 1%, 0.5%, 0.5%, and 0.5%, respectively. The mixed material was then melt-extruded through a twin-screw extruder, followed sequentially by casting and thermal crosslinking treatment to obtain an ultraviolet cut-off encapsulant film.

Among them, the components of the composite ultraviolet cut-off agent were as follows: pentaerythritol tetrakis(2-cyano-3,3-diphenylacrylate), 2-(4,6-diphenyl-1,3,5-triazin-2-yl)-5-(hexyloxy)phenol, hexadecyl 3,5-di-tert-butyl-4-hydroxybenzoate, 3,5-di-tert-butyl-4-hydroxybenzoic acid 2,4-di-tert-butylphenyl ester, 2,4-bis(2,4-dimethylphenyl)-6-(2-hydroxy-4-octyloxyphenyl)-1,3,5-triazine, and 2'-(2'-hydroxy-3'-tert-butyl-5'-methylphenyl)-5-chlorobenzotriazole. The mass percentages of the above components in the composite ultraviolet cut-off agent were 20%, 10%, 20%, 12%, 25%, and 13%, respectively.

### (2) Solar cell module Preparation

A photovoltaic glass cover plate having a thickness of 2 mm, the aforementioned ultraviolet cut-off encapsulant film with a basis weight of 420 g/m², a TOPCon solar cell, the aforementioned ultraviolet cut-off encapsulant film with a basis weight of 420 g/m², and a photovoltaic glass cover plate having a thickness of 2 mm were sequentially stacked and laminated to obtain a TOPCon solar cell module. Among them, the TOPCon solar cell had a silicon nitride anti-reflection layer having a thickness of 85nm on both the front side and the back side thereof; the photovoltaic glass cover plate had an average transmittance for light in a wavelength range below 320 nm of less than 51%.

### Example 8:

The example was basically the same as Example 7, with the difference being that in step (1), the mass percentages of EVA as a polymer matrix, a composite ultraviolet cut-off agent, di(tert-butylperoxyisopropyl)benzene as a crosslinking agent, P-EPQ as an antioxidant, zinc stearate as a heat stabilizer, petroleum resin as a tackifying resin, KH570 silane coupling agent as a coupling agent, and triallyl cyanurate as a co-crosslinking agent were 95.0%, 1.0%, 1.0%, 0.5%, 1%, 0.5%, 0.5%, and 0.5%, respectively.

### Example 9:

The example was basically the same as Example 7, with the difference being that in step (1), the mass percentages of EVA as a polymer matrix, a composite ultraviolet cut-off agent, di(tert-butylperoxyisopropyl)benzene as a crosslinking agent, P-EPQ as an antioxidant, zinc stearate as a heat stabilizer, petroleum resin as a tackifying resin, KH570 silane coupling agent as a coupling agent, and triallyl cyanurate as a co-crosslinking agent were 95.95%, 0.05%, 1.0%, 0.5%, 1%, 0.5%, 0.5%, and 0.5%, respectively.

### Example 10:

The example was basically the same as Example 7, with the difference being that in step (1), the components of the composite ultraviolet cut-off agent were as follows: pentaerythritol tetrakis(2-cyano-3,3-diphenylacrylate), 2-(4,6-diphenyl-1,3,5-triazin-2-yl)-5-(hexyloxy)phenol, hexadecyl 3,5-di-tert-butyl-4-hydroxybenzoate, 3,5-di-tert-butyl-4-hydroxybenzoic acid 2,4-di-tert-butylphenyl ester, 2,4-bis(2,4-dimethylphenyl)-6-(2-hydroxy-4-octyloxyphenyl)-1,3,5-triazine, and 2'-(2'-hydroxy-3'-tert-butyl-5'-methylphenyl)-5-chlorobenzotriazole. The mass percentages of the above components in the composite ultraviolet cut-off agent were 18%, 8%, 19%, 15%, 20%, and 20%, respectively.

### Comparative Example 1:

The comparative example was basically the same as Example 1, with the difference being that phenyl salicylate was used instead of 2-methylbutyl salicylate as the single-component ultraviolet cut-off agent.

### Comparative Example 2:

The comparative example was basically the same as Example 3, with the difference being that pentaerythritol tetrakis(2-cyano-3,3-diphenylacrylate) was not used in the composite ultraviolet cut-off agent; and the mass percentage of 2-(4,6-diphenyl-1,3,5-triazin-2-yl)-5-(hexyloxy)phenol was increased to 30%.

That is, the components of the composite ultraviolet cut-off agent were as follows: 2-(4,6-diphenyl-1,3,5-triazin-2-yl)-5-(hexyloxy)phenol, hexadecyl 3,5-di-tert-butyl-4-hydroxybenzoate, 3,5-di-tert-butyl-4-hydroxybenzoic acid 2,4-di-tert-butylphenyl ester, 2,4-bis(2,4-dimethylphenyl)-6-(2-hydroxy-4-octyloxyphenyl)-1,3,5-triazine, and 2'-(2'-hydroxy-3'-tert-butyl-5'-methylphenyl)-5-chlorobenzotriazole. The mass percentages of the above components in the composite ultraviolet cut-off agent were 30%, 20%, 12%, 25%, and 13%, respectively.

### Comparative Example 3:

The comparative example was basically the same as Example 3, with the difference being that 2-(4,6-diphenyl-1,3,5-triazin-2-yl)-5-(hexyloxy)phenol, hexadecyl 3,5-di-tert-butyl-4-hydroxybenzoate, and 3,5-di-tert-butyl-4-hydroxybenzoic acid 2,4-di-tert-butylphenyl ester were not used in the composite ultraviolet cut-off agent; the mass percentage of pentaerythritol tetrakis(2-cyano-3,3-diphenylacrylate) was increased to 62%.

That is, the components of the composite ultraviolet cut-off agent were as follows: pentaerythritol tetrakis(2-cyano-3,3-diphenylacrylate), 2,4-bis(2,4-dimethylphenyl)-6-(2-hydroxy-4-octyloxyphenyl)-1,3,5-triazine, and 2'-(2'-hydroxy-3'-tert-butyl-5'-methylphenyl)-5-chlorobenzotriazole. The mass percentages of the above components in the composite ultraviolet cut-off agent were 62%, 25%, and 13%, respectively.

### Performance Testing:

### (1) Transmittance test of encapsulant film

The transmittance of the encapsulant film having a basis weight of 420 g/m² was tested over a wavelength range of 280 nm to 1200 nm using an UV-Vis spectrophotometer with a step size of 1 nm. A transmittance curve of the encapsulant film was plotted with transmittance as the vertical axis and wavelength as the horizontal axis. The average transmittance of the encapsulant film within specific wavelength ranges was calculated. Among them, the average transmittance refers to the average value of transmittance measured at a plurality of specific wavelengths within that wavelength range. For example, for measuring the average transmittance for light in a wavelength range of 320 nm to 330 nm, the transmittance for light at each wavelength of 320 nm, 321 nm, 322 nm, 323 nm... 328 nm, 329 nm, 330 nm was measured, and the average value of the measurement data was calculated.

### (2) Stability test of solar cell module

### (2.1) UV240 kWh/m² aging power degradation test

The initial output power P0 of the solar cell module was tested using an IV test equipment under standard test conditions of 25°C, AM1.5 spectrum, and 1000W/m² light intensity. The solar cell module was placed in an ultraviolet chamber and subjected to ultraviolet irradiation aging at 60°C. During the aging process, the irradiation intensity was 150 W/m², the irradiation wavelength was 280 nm to 400nm, and the ultraviolet radiation dose was 240 kWh/m². After the aging test, the solar cell module was left to stand in a dark environment at 25°C and a humidity of ≤40% for 8 hours, and then the I-V characteristic curve of the module was retested under standard test conditions to obtain the module power P1. The module power degradation η was calculated as η = (P0 - P1) / P0 × 100%. A larger power degradation indicates poorer stability of the module; conversely, it indicates better stability of the module.

### (2.2) DH500 + UV75 kWh/m² aging power degradation test

The initial output power P0 of the solar cell module was tested using an IV test equipment under standard test conditions of 25°C, AM1.5 spectrum, and 1000W/m² light intensity. The solar cell module was placed in an ultraviolet chamber and treated at 85°C and a relative humidity of 85% for 500 hours, while simultaneously subjecting the solar cell module to ultraviolet irradiation aging. During the aging process, the irradiation intensity was 150W/m², the irradiation wavelength was 280 nm to 400nm, and the ultraviolet radiation dose was 75 kWh/m². After the aging test, the solar cell module was left to stand in a dark environment at 25°C and a humidity of ≤40% for 8 hours, and then the I-V characteristic curve of the module was retested under standard test conditions to obtain the module power P1. The module power degradation η was calculated as η = (P0 - P1) / P0 × 100%. A larger power degradation indicates poorer stability of the module; conversely, it indicates better stability of the module.

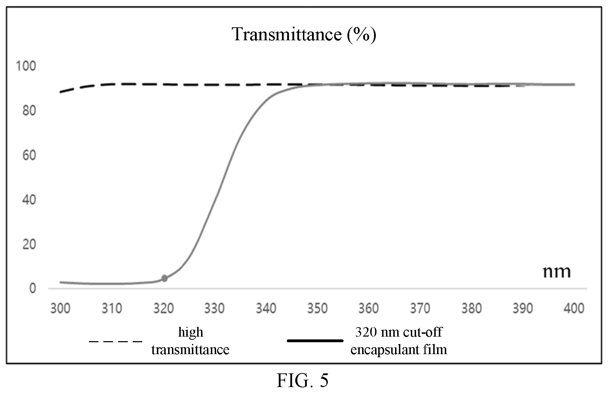

The transmittance curve of the ultraviolet cut-off encapsulant film of Example 7 of the present application is shown in FIG. 5. In FIG. 5, the BSL (high transmittance) curve is the transmittance curve of a high-transmittance encapsulant film without ultraviolet cut-off agent, and the 320 nm cut-off encapsulant film curve is the transmittance curve of the ultraviolet cut-off encapsulant film of Example 7. As can be seen from FIG. 5, the ultraviolet cut-off encapsulant film of Example 7 has a very high cut-off rate for ultraviolet light below 320 nm wavelength. Its transmittance for light at a wavelength of 320 nm is only about 4.44%, which may effectively reduce the adverse effects of ultraviolet light below 320 nm on the solar cell module. Furthermore, its average transmittance for light above 360 nm wavelength is above 90%, and it has a high slope in the wavelength range of 320 nm to 360 nm, which is beneficial for increasing the utilization of light above 320 nm wavelength by the solar cell module and improving the output power of the solar cell module.

The average transmittance for different wavelength ranges of the encapsulant films and the performance data of the solar cell modules of the above examples and comparative examples are shown in Table 1 and Table 2.

**Table 1**

| Item | Average Transmittance (%) 280-320 nm | Average Transmittance (%) 320-330 nm | Average Transmittance (%) 330-340 nm | Average Transmittance (%) 340-350 nm | Average Transmittance (%) 350-360 nm | Average Transmittance (%) 360-370 nm | Average Transmittance (%) 370-380 nm | Average Transmittance (%) 380-1200 nm |
|---|---|---|---|---|---|---|---|---|
| Example 1 | 1.39 | 28.95 | 62.03 | 86.37 | 89.09 | 91.97 | 91.23 | 92.95 |
| Example 2 | 1.56 | 25.67 | 60.89 | 85.45 | 89.01 | 91.22 | 91.56 | 92.78 |
| Example 3 | 0.89 | 22.99 | 60.34 | 85.12 | 88.66 | 90.33 | 90.67 | 91.89 |
| Example 4 | 1.42 | 29.56 | 61.09 | 85.32 | 88.56 | 91.46 | 91.65 | 92.89 |
| Example 5 | 1.44 | 27.45 | 62.22 | 85.22 | 89.33 | 91.66 | 90.34 | 91.67 |
| Example 6 | 1.52 | 27.89 | 61.77 | 85.55 | 89.77 | 90.89 | 90.78 | 92.22 |
| Example 7 | 3.67 | 28.86 | 62.12 | 86.35 | 89.12 | 91.95 | 91.20 | 91.96 |
| Example 8 | 3.67 | 29.34 | 60.99 | 87.76 | 89.44 | 90.11 | 90.67 | 91.10 |
| Example 9 | 4.12 | 26.78 | 62.33 | 87.89 | 88.88 | 90.89 | 90.89 | 92.45 |
| Example 10 | 1.23 | 26.5 | 63.44 | 86.22 | 89.44 | 90.66 | 90.78 | 91.01 |
| Comparative Example 1 | 3.68 | 5.68 | 32.950 | 52.06 | 68.96 | 85.46 | 91.25 | 92.81 |
| Comparative Example 2 | 5.09 | 12.56 | 44.69 | 59.68 | 72.95 | 89.56 | 90.25 | 92.94 |
| Comparative Example 3 | 2.56 | 20.08 | 56.26 | 67.86 | 78.92 | 89.05 | 90.98 | 92.91 |

**Table 2**

| Item | UV240 kWh/m² Aging Power Degradation (%) | DH500 + UV75 kWh/m² Aging Power Degradation (%) | Initial Output Power (W) |
|---|---|---|---|
| Example 1 | 1.99 | 1.29 | 626.9 |
| Example 2 | 1.64 | 0.96 | 622.2 |
| Example 3 | 2.35 | 2.08 | 621.5 |
| Example 4 | 2.04 | 1.32 | 623.0 |
| Example 5 | 2.09 | 1.38 | 620.3 |
| Example 6 | 1.85 | 1.49 | 618.6 |
| Example 7 | 2.05 | 2.97 | 617.9 |
| Example 8 | 2.12 | 2.93 | 616.2 |
| Example 9 | 2.29 | 3.13 | 623.1 |
| Example 10 | 2.06 | 2.55 | 615.6 |
| Comparative Example 1 | 5.25 | 3.09 | 611 |
| Comparative Example 2 | 7.05 | 3.15 | 609 |
| Comparative Example 3 | 8.55 | 4.02 | 612 |

As can be seen from Table 1 and Table 2, in Examples 1 to 10 of the present application, the ultraviolet cut-off encapsulant film has a low transmittance for light in the wavelength band below 320 nm, a high transmittance for light in the wavelength band above 360 nm, and a relatively high slope of the transmittance curve in the wavelength band from 320 nm to 360 nm. Compared with Comparative Examples 1 to 3, the solar cell modules of Examples 1 to 10 of the present application exhibit smaller power degradation after aging, thereby indicating that the solar cell modules have better stability, and also show higher initial output power of the solar cell modules.

The technical features of the embodiments described above may be combined arbitrarily. For the sake of brevity, not all possible combinations of the technical features in the above embodiments have been described. However, as long as there is no contradiction in the combination of these technical features, such combinations shall be considered to fall within the scope of the present specification.

The above-described embodiments merely represent several implementations of the present application, and the descriptions thereof are relatively specific and detailed, but should not be construed as limiting the scope of the patent of the present application. It should be pointed out that for those of ordinary skill in the art, several modifications and improvements may be made without departing from the concept of the present application, and such variations and improvements shall fall within the protection scope of the present application. Therefore, the protection scope of the present application shall be subject to the appended claims, and the specification and drawings may be used to explain the content of the claims.

## Claims

1. A solar cell module (100), comprising a first cover plate (101), a first encapsulant film (102), a solar cell (103), a second encapsulant film (104), and a second cover plate (105), wherein the first cover plate (101), the first encapsulant film (102), the second encapsulant film (104), and the second cover plate (105) are sequentially stacked, and the solar cell (103) is located between the first encapsulant film (102) and the second encapsulant film (104); and
at least one of the first encapsulant film (102) and the second encapsulant film (104) independently satisfies the following conditions: an average transmittance for light in a wavelength range of 280 nm to 320 nm is less than or equal to 5%, an average transmittance for light in a wavelength range of 320 nm to 330 nm is from 25% to 30%, an average transmittance for light in a wavelength range of 330 nm to 340 nm is from 60% to 65%, an average transmittance for light in a wavelength range of 340 nm to 350 nm is from 85% to 88%, an average transmittance for light in a wavelength range of 350 nm to 360 nm is from 88% to 90%, and an average transmittance for light in a wavelength range above 360 nm is greater than or equal to 90%.

2. The solar cell module (100) according to claim 1, wherein a light-receiving surface of the solar cell (103) is provided with an anti-reflection coating layer (106), a thickness of the anti-reflection coating layer (106) ranges from 75 nm to 95 nm, and a refractive index of the anti-reflection coating layer (106) ranges from 1.9 to 2.2.

3. The solar cell module (100) according to claim 2, wherein the thickness of the anti-reflection coating layer (106) ranges from 70 nm to 90 nm, and the refractive index of the anti-reflection coating layer (106) ranges from 2.00 to 2.05.

4. The solar cell module (100) according to claim 2, wherein a material of the anti-reflection coating layer (106) comprises one or more of silicon nitride, silicon oxide, and silicon oxynitride.

5. The solar cell module (100) according to any one of claims 1 to 4, wherein at least one of the first cover plate (101) and the second cover plate (105) is a photovoltaic glass, and an average transmittance of the photovoltaic glass for light in a wavelength range below 320 nm is less than or equal to 51%.

6. The solar cell module (100) according to claim 5, wherein a thickness of the photovoltaic glass ranges from 1.6 mm to 3.2 mm.

7. The solar cell module (100) according to any one of claims 1 to 4 and 6, wherein at least one of the first encapsulant film (102) and the second encapsulant film (104) contains 0.1% to 0.5% by mass of the encapsulant film of butyl 2-methylsalicylate, or contains 0.05% to 0.3% by mass of the encapsulant film of 2-(2'-hydroxy-3',5'-dicumenylphenyl)benzotriazole.

8. The solar cell module (100) according to any one of claims 1 to 4 and 6, wherein at least one of the first encapsulant film (102) and the second encapsulant film (104) contains 0.05% to 1% by mass of the encapsulant film of a composite ultraviolet cut-off agent, and the composite ultraviolet cut-off agent comprises the following components in mass percentage: 18% to 20% of a cyanoacrylate-based ultraviolet absorber, 8% to 10% of a triazine-based ultraviolet absorber, 28% to 32% of a hydroxybenzoate-based ultraviolet absorber, and 30% to 46% of an auxiliary additive.

9. The solar cell module (100) according to claim 8, wherein at least one of the following is satisfied:
(1) the cyanoacrylate-based ultraviolet absorber comprises pentaerythritol tetrakis(2-cyano-3,3-diphenylacrylate);
(2) the triazine-based ultraviolet absorber comprises 2-(4,6-diphenyl-1,3,5-triazin-2-yl)-5-(hexyloxy)phenol;
(3) the hydroxybenzoate-based ultraviolet absorber comprises one or more of hexadecyl 3,5-di-tert-butyl-4-hydroxybenzoate and 3,5-di-tert-butyl-4-hydroxybenzoic acid 2,4-di-tert-butylphenyl ester;
wherein the hydroxybenzoate-based ultraviolet absorber comprises hexadecyl 3,5-di-tert-butyl-4-hydroxybenzoate and 3,5-di-tert-butyl-4-hydroxybenzoic acid 2,4-di-tert-butylphenyl ester; and
based on a total mass of the composite ultraviolet cut-off agent, a mass percentage of the hexadecyl 3,5-di-tert-butyl-4-hydroxybenzoate ranges from 18% to 22%, and a mass percentage of the 3,5-di-tert-butyl-4-hydroxybenzoic acid 2,4-di-tert-butylphenyl ester ranges from 10% to 14%.

10. The solar cell module (100) according to claim 8, wherein the auxiliary additive comprises one or more of 2,4-bis(2,4-dimethylphenyl)-6-(2-hydroxy-4-octyloxyphenyl)-1,3,5-triazine, 2'-(2'-hydroxy-3'-tert-butyl-5'-methylphenyl)-5-chlorobenzotriazole, 2-(2H-benzotriazol-2-yl)-4,6-bis(1-methyl-1-phenylethyl)phenol, 2-(2'-hydroxy-3',5'-di-tert-pentylphenyl)benzotriazole, 2-(2H-benzotriazol-2-yl)-6-(1-methyl-1-phenylethyl)-4-(1,1,3,3-tetramethylbutyl)phenol, 2-(2'-hydroxy-3',5'-di-tert-butylphenyl)-5-chlorobenzotriazole, 2-(2'-hydroxy-5'-tert-octylphenyl)benzotriazole, 2-hydroxy-4-n-octoxybenzophenone, 2,2'-methylenebis[6-(2H-benzotriazol-2-yl)-4-(1,1,3,3-tetramethylbutyl)phenol], 2-(2'-hydroxy-5'-methylphenyl)benzotriazole, a mixture of 2-[4-[(2-hydroxy-3-tridecyloxypropyl)oxy]-2-hydroxyphenyl]-4,6-bis(2,4-dimethylphenyl)-1,3,5-triazine and 2-[4-[(2-hydroxy-3-dodecyloxypropyl)oxy]-2-hydroxyphenyl]-4,6-bis(2,4-dimethylphenyl)-1,3,5-triazine, octyl 3-(3-(2H-benzo[d][1,2,3]triazol-2-yl)-5-(tert-butyl)-4-hydroxyphenyl)propanoate, and 3-[3-(2H-benzotriazol-2-yl)-4-hydroxy-5-tert-butylphenyl]-propionic acid-polyethylene glycol 300 ester.

11. The solar cell module (100) according to claim 10, wherein the auxiliary additive comprises 2,4-bis(2,4-dimethylphenyl)-6-(2-hydroxy-4-octyloxyphenyl)-1,3,5-triazine and 2'-(2'-hydroxy-3'-tert-butyl-5'-methylphenyl)-5-chlorobenzotriazole;
wherein, based on a total mass of the composite ultraviolet cut-off agent, a mass percentage of the 2,4-bis(2,4-dimethylphenyl)-6-(2-hydroxy-4-octyloxyphenyl)-1,3,5-triazine ranges from 20% to 25%, and a mass percentage of the 2'-(2'-hydroxy-3'-tert-butyl-5'-methylphenyl)-5-chlorobenzotriazole ranges from 10% to 22%.

12. The solar cell module (100) according to any one of claims 1 to 4, 6, and 9 to 11, wherein at least one of the first encapsulant film (102) and the second encapsulant film (104) comprises 90% to 97.65% by mass of the encapsulant film of a polymer matrix; the polymer matrix comprises one or more of ethylene-vinyl acetate copolymer, ethylene-octene copolymer, polyethylene, thermoplastic polyurethane, polyvinyl butyral, and polyethylene terephthalate.

13. The solar cell module (100) according to any one of claims 1 to 4, 6, and 9 to 11, wherein at least one of the first encapsulant film (102) and the second encapsulant film (104) comprises one or more of a crosslinking agent, an antioxidant, a heat stabilizer, a tackifying resin, a plasticizer, a coupling agent, and a co-crosslinking agent, the crosslinking agent is present in an amount of 1.0% to 1.2% by mass of the encapsulant film, the antioxidant is present in an amount of 0.2% to 0.5% by mass of the encapsulant film, the heat stabilizer is present in an amount of 0.8% to 1% by mass of the encapsulant film, the tackifying resin is present in an amount of 0% to 0.5% by mass of the encapsulant film, the plasticizer is present in an amount of 0% to 1.5% by mass of the encapsulant film, the coupling agent is present in an amount of 0.3% to 0.5% by mass of the encapsulant film, and the co-crosslinking agent is present in an amount of 0% to 0.5% by mass of the encapsulant film.

14. The solar cell module (100) according to claim 13, wherein at least one of the following is satisfied:
(1) the crosslinking agent comprises one or more of an alkyl peroxide crosslinking agent, a diacyl peroxide crosslinking agent, and a peroxyketal crosslinking agent;
(2) the antioxidant comprises a phosphite antioxidant;
(3) the heat stabilizer comprises one or more of a phosphite heat stabilizer, a fatty acid salt heat stabilizer, and an epoxy compound heat stabilizer;
(4) the tackifying resin comprises one or more of a terpene resin, a petroleum resin, a styrenic copolymer resin, and a phenolic resin;
(5) the plasticizer comprises one or more of a phthalate plasticizer, an epoxy compound plasticizer, and a polyester plasticizer;
(6) the coupling agent comprises a silane coupling agent;
(7) the co-crosslinking agent comprises one or more of a multifunctional olefinic co-crosslinking agent, a peroxide co-crosslinking agent, and a silane co-crosslinking agent.

15. A photovoltaic power generation system, comprising the solar cell module (100) according to any one of claims 1 to 14.
